# FASCICULE DE BREVET EUROPEEN

(11) **EP 3 900 064 B1**
(45) Date de publication et mention de la délivrance du brevet: **03.05.2023**
(21) Numéro de dépôt: 19842811.2
(22) Date de dépôt: 12.12.2019
(51) Int. Cl.: H10N 30/072

(54) **PROCEDE DE TRANSFERT D'UNE COUCHE SUPERFICIELLE SUR DES CAVITES**
VERFAHREN ZUM ÜBERTRAGEN EINER OBERFLÄCHENSCHICHT AUF HOHLRÄUME
METHOD FOR TRANSFERRING A SURFACE LAYER TO CAVITIES

(30) Priorité: 20.12.2018 FR 1873597
(43) Date de publication de la demande: 27.10.2021
(73) Titulaire: SOITEC, 38190 Bernin (FR)
(72) Inventeur: GHYSELEN, Bruno, 38170 SEYSSINET (FR)
(74) Mandataire: IP Trust
(86) Numéro de dépôt international: PCT/FR2019/053038
(87) Numéro de publication internationale: WO 2020/128244

(56) Documents cités:
- WO-A1-2017/207911
- WO-A1-2018/014438

## Description

### DOMAINE DE L'INVENTION

La présente invention concerne le domaine de la microélectronique et des microsystèmes. Elle concerne en particulier un procédé de transfert d'une couche superficielle sur un substrat comprenant un réseau de cavités.

### ARRIERE PLAN TECHNOLOGIQUE DE L'INVENTION

Les dispositifs MEMS (« Microelectromechanical systems ») sont largement utilisés pour la fabrication de capteurs divers, visant une multitude d'applications : on peut citer par exemple, les capteurs de pression, les microphones, les interrupteurs radiofréquence, les transducteurs électroacoustiques et ultrasonores (par exemple pMUT « Piezoelectric Micromachined Ultrasonic Transducer »), etc.

Beaucoup de ces dispositifs MEMS sont basés sur une membrane flexible surplombant une cavité. En fonctionnement, le fléchissement de la membrane, lié à un paramètre physique (par exemple la propagation d'une onde acoustique pour un pMUT), est converti en un signal électrique (ou vice-versa selon que le dispositif est en mode récepteur ou émetteur).

Pour améliorer les performances de ces dispositifs MEMS sur cavités, il peut être utile d'avoir une membrane présentant une bonne qualité cristalline et une épaisseur uniforme et bien contrôlée. Les substrats de type SOI (pour « Silicon on Insulator ») sont particulièrement adaptés pour la fabrication de ces dispositifs en ce qu'ils offrent une couche superficielle de très bonne qualité, pour former la membrane, et une couche d'oxyde enterré (et/ou un substrat support), pour accueillir la cavité sous-jacente.

La publication de Lu Yipeng et David A. Horsley, "Modeling, fabrication, and characterization of piezoelectric micromachined ultrasonic transducer arrays based on cavity SOI wafers." (Journal of Microelectromechanical Systems 24.4 (2015) 1142-1149) présente un exemple de fabrication d'un dispositif pMUT à partir d'un substrat SOI à cavités enterrées et les avantages que cela procure. Un autre exemple se trouve dans le document WO2018/014438.

Selon le type de dispositif mis en oeuvre, la géométrie de la cavité (forme, dimensions latérales, profondeur), de la membrane (épaisseur) et leur répartition planaire (distance inter-cavités) seront différentes. Dans certaines configurations de géométrie et répartition, il peut ainsi s'avérer complexe de fabriquer des substrats comprenant une couche superficielle disposée sur une pluralité de cavités, et en particulier de définir un procédé de transfert compatible avec le report d'une couche superficielle de faible épaisseur sur des cavités de grandes dimensions.

### OBJET DE L'INVENTION

La présente invention vise à pallier tout ou partie des inconvénients précités. Elle concerne un procédé de transfert d'une couche superficielle sur un substrat comprenant une pluralité de cavités.

### BREVE DESCRIPTION DE L'INVENTION

L'invention concerne un procédé de transfert d'une couche superficielle sur un substrat support comportant des cavités, le procédé comprenant :
- La fourniture d'un substrat donneur,
- La fourniture du substrat support présentant une première face et comportant des cavités, chaque cavité débouchant au niveau de ladite première face et présentant un fond et des parois périphériques,
- La réalisation d'au moins un pilier temporaire dans au moins une des cavités, le pilier présentant une surface supérieure coplanaire avec la première face du substrat support,
- L'assemblage du substrat donneur et du substrat support au niveau de la première face du substrat support,
- L'amincissement du substrat donneur de manière à former la couche superficielle,
- Le retrait du au moins un pilier temporaire.

Selon d'autres caractéristiques avantageuses et non limitatives de l'invention, prises seules ou selon toute combinaison techniquement réalisable :
- la fourniture du substrat donneur comprend l'implantation d'espèces légères dans ledit substrat donneur, de manière à former une zone fragile enterrée s'étendant entre une première partie du substrat donneur, destinée à former la couche superficielle, et une deuxième partie du substrat donneur destinée à former le reste du substrat donneur,
- l'amincissement du substrat donneur comprend la séparation, au niveau de la zone fragile enterrée, entre la couche superficielle et le reste du substrat donneur ;
- la première partie du substrat donneur présente une épaisseur comprise entre 0,2 µm et 2 µm ;
- le au moins un pilier est disjoint des parois périphériques de la cavité ;
- la surface supérieure du pilier présente un contour circulaire, carré, rectangulaire ou en croix ;
- le au moins un pilier rejoint au moins une paroi périphérique de la cavité ;
- la surface supérieure du au moins un pilier forme un quadrillage joignant les parois périphériques de la cavité ;
- une pluralité de piliers forme un réseau de parois parallèles rejoignant en leurs extrémités des parois périphériques de la cavité ;
- l'assemblage comprend le collage par adhésion moléculaire entre, d'une part, le substrat donneur, et d'autre part, la première face du substrat support et la surface supérieure du au moins un pilier ;
- le retrait du pilier comprend la gravure locale de la couche superficielle pour former une ouverture traversant ladite couche superficielle, et la gravure chimique du pilier via ladite ouverture ;
- la gravure chimique du pilier se fait par gravure sèche ou humide ;
- l'ouverture est faite à l'aplomb du pilier ;
- l'ouverture présente une section inférieure ou égale à la surface supérieure du pilier ;
- l'ouverture présente une section supérieure à la surface supérieure du pilier ;
- l'ouverture est faite dans la couche superficielle en-dehors de zones surplombant la au moins une cavité ;
- le retrait du pilier comprend la gravure locale de la seconde face du substrat support jusqu'à la cavité, pour former une ouverture communiquant avec ladite cavité, et la gravure chimique du pilier via ladite ouverture ;
- le pilier comprend au moins un matériau compris parmi l'oxyde de silicium, le nitrure de silicium, le silicium monocristallin, poly-cristallin, amorphe ou poreux ;
- le substrat donneur comprend au moins un matériau semi-conducteur ou piézoélectrique.

### BREVE DESCRIPTION DES FIGURES

D'autres caractéristiques et avantages de l'invention ressortiront de la description détaillée de l'invention qui va suivre en référence aux figures annexées sur lesquelles :

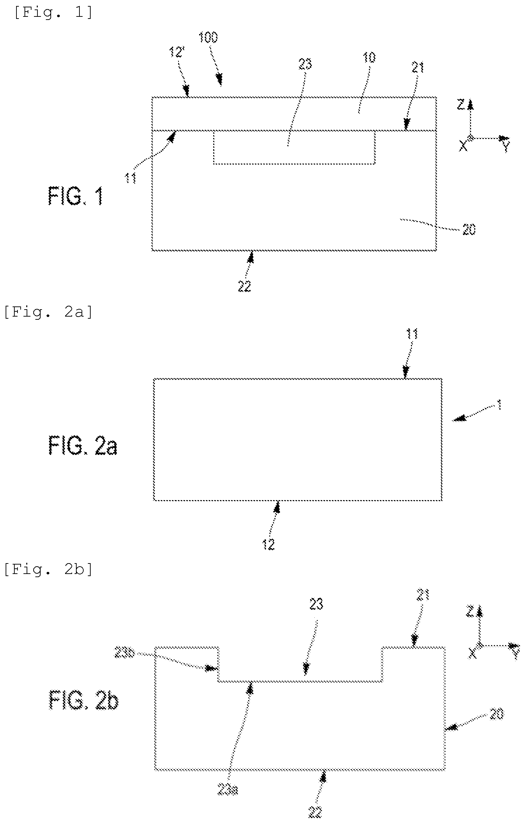

[Fig. 1] La figure 1 représente une structure comprenant une couche superficielle disposée sur des cavités enterrées, obtenue à partir d'un procédé de transfert conforme à l'invention ;
[Fig. 2a]
[Fig. 2b]
[Fig. 2c]
[Fig. 2d]
[Fig. 2e]
[Fig. 2f]
[Fig. 2g]
[Fig. 2h]
[Fig. 2i]

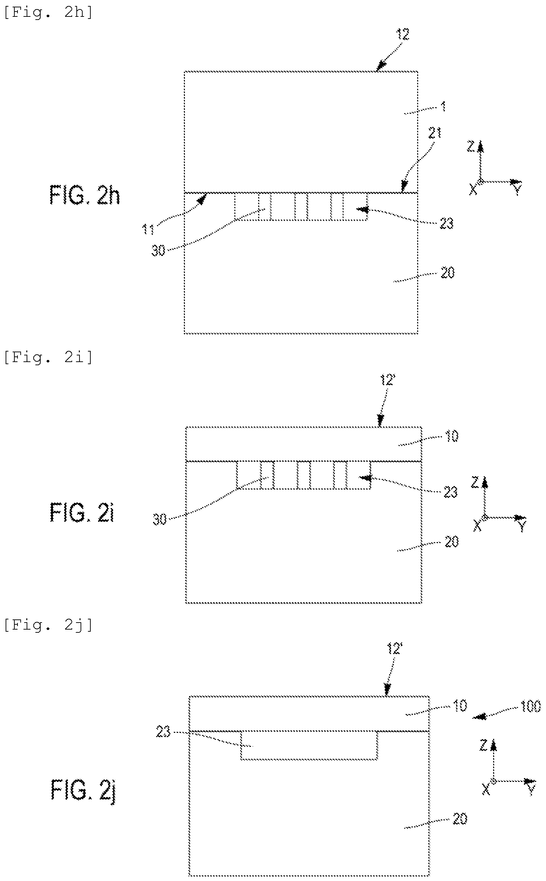

[Fig. 2j] Les figures 2a à 2j représentent des étapes d'un procédé de transfert conforme à l'invention ;
[Fig. 3a]
[Fig. 3b]

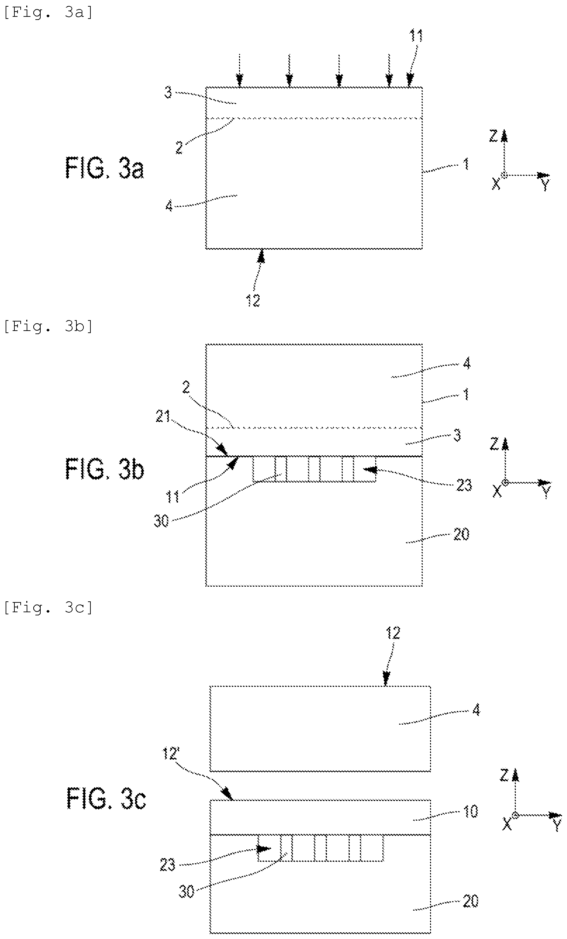

[Fig. 3c] Les figures 3a à 3c représentent d'autres étapes d'un procédé de transfert conforme à l'invention ;
[Fig. 4a]
[Fig. 4b]

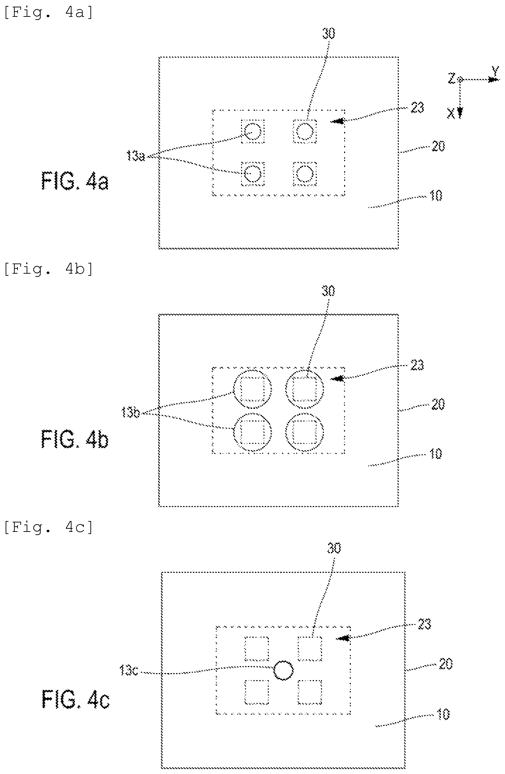

[Fig. 4c] Les figures 4a à 4c représentent des variantes d'une étape de retrait des piliers temporaires comprise dans un procédé de transfert conforme à l'invention ;
[Fig. 5a]
[Fig. 5b]
[Fig. 5c]
[Fig. 5d]
[Fig. 5e]
[Fig. 5f]
[Fig. 5g]
[Fig. 5h]

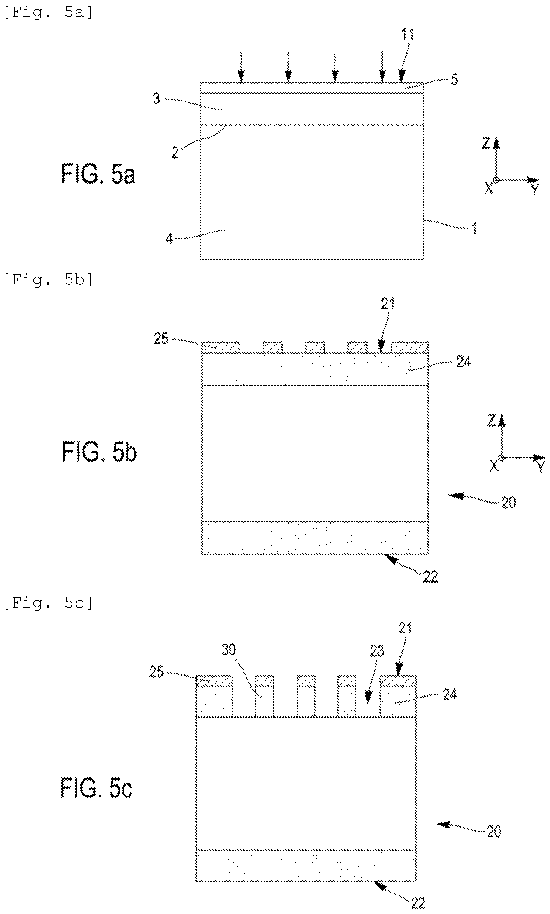

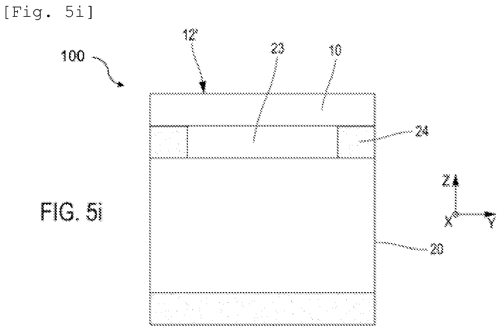

[Fig. 5i] Les figures 5a à 5i représentent un exemple de réalisation du procédé de transfert conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

L'invention concerne un procédé de transfert d'une couche superficielle 10 sur un substrat support 20 comportant des cavités 23 (figure 1), ledit procédé de transfert menant à la fabrication d'une structure 100 à cavités enterrées 23.

Le procédé selon l'invention comprend une étape de fourniture d'un substrat donneur 1 présentant une face avant 11, destinée à être assemblée sur le substrat support 20 et une face arrière 12 (figure 2a). A titre d'exemple, et sans que cela soit limitatif, le substrat donneur 1 pourra comprendre au moins un matériau semi-conducteur, par exemple du silicium, du carbure de silicium, du nitrure de gallium, etc, ou un matériau piézoélectrique, par exemple du tantalate de lithium, du niobate de lithium, du nitrure d'aluminium, de l'oxyde de zinc, du PZT, etc.

Le procédé comprend également une étape de fourniture du substrat support 20 (figure 2b) ; ce dernier présente une première face 21 destinée à être assemblée sur le substrat donneur 1 et une seconde face 22. A titre d'exemple non limitatif, le substrat support 20 pourra comprendre du silicium, du verre, du saphir, etc. Le substrat support 20 comporte une pluralité de cavités 23 débouchant au niveau de sa première face 21. Chaque cavité 23 présente un fond 23a et des parois périphériques 23b.

La géométrie de chaque cavité 23, qui dépend du dispositif MEMS visé, est définie par :
- la forme de la cavité 23 dans le plan de la première face 21 du substrat support 20 (dit plan principal (x,y) dans la suite de la description) : elle pourra être circulaire, carrée, rectangulaire ou polygonale ;
- les dimensions latérales de la cavité 23, dans le plan principal (x,y) : elles pourront varier de quelques microns à quelques millimètres ;
- la profondeur de la cavité 23, selon l'axe z normal au plan principal (x,y) : elle pourra varier de quelques dizaines de nanomètres à quelques dizaines de microns, voire quelques centaines de microns.

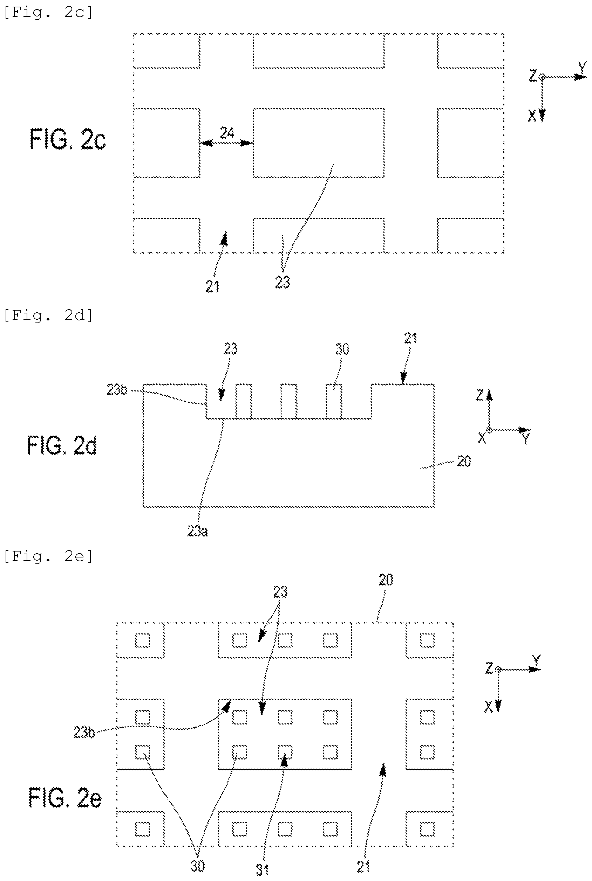

La répartition planaire des cavités 23, c'est-à-dire leur répartition dans le plan principal (x,y) dépend également du dispositif visé et va définir l'espacement inter-cavités 24 (figure 2c) : il pourra varier de quelques microns à quelques centaines de microns, voire à quelques millimètres. L'espacement inter-cavités 24 pourra être uniforme et identique sur toute la surface du substrat support 20 ou varier selon les zones à la surface dudit substrat support 20.

Notons que le substrat support 20 pourra comporter des cavités 23 présentant des formes, dimensions latérales, profondeurs et/ou répartitions planaires différentes, en particulier s'il est prévu de co-intégrer des dispositifs de différents types sur la structure 100 à cavités enterrées.

Diverses couches pourront être déposées sur le fond 23a et/ou sur les parois 23b des cavités 23 (par exemple, en nitrure de silicium, en oxyde de silicium, etc.) selon le type de dispositif MEMS destiné à être élaboré sur la structure 100 à cavités enterrées 23.

Le procédé de transfert selon l'invention prévoit en outre une étape de réalisation d'au moins un pilier temporaire 30 dans au moins une des cavités 23, et préférentiellement dans chaque cavité 23 (figure 2d). En fonction des dimensions latérales de chaque cavité 23, le nombre et le positionnement des piliers 30 pourra être adapté.

Le pilier 30 présente une surface supérieure 31, dans le plan principal (x,y), coplanaire avec la première face 21 du substrat support 20. La surface inférieure du pilier 30 est solidaire du fond 23a de la cavité 23.

A titre d'exemple, et sans que cela soit limitatif, le pilier 30 comprend au moins un matériau parmi l'oxyde de silicium, le nitrure de silicium, le silicium monocristallin, polycristallin, amorphe ou poreux.

Selon une première variante, le (ou les) pilier(s) 30 est(sont) disjoint(s) des parois périphériques 23b de la cavité 23. Comme illustré sur la figure 2e, les piliers 23 ne sont pas en contact avec les parois 23b de la cavités 23. Préférentiellement, ils sont distribués uniformément sur le fond 23a de chaque cavité 23.

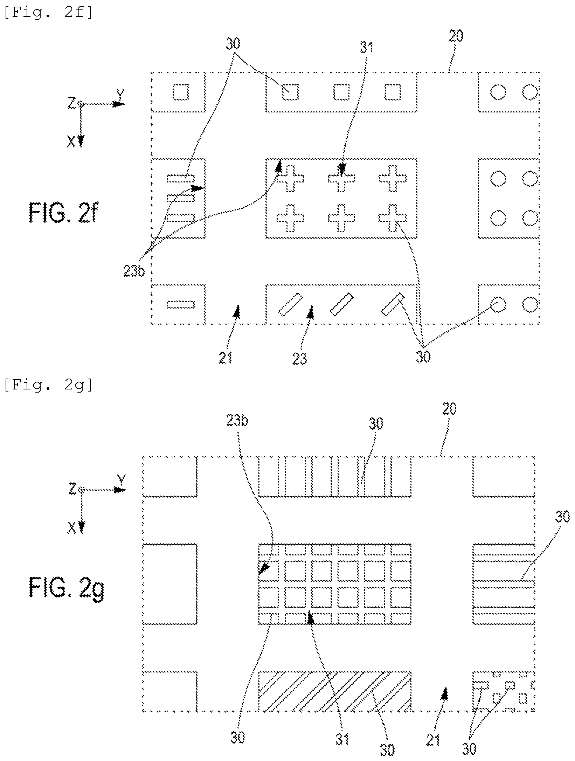

La surface supérieure 31 du pilier 30 pourra présenter différents types de contours, dont quelques exemples sont illustrés sur la figure 2f : un contour circulaire, carré, rectangulaire ou en croix.

Selon cette première variante, le pilier 30 pourra présenter des dimensions allant de quelques microns à environ 15 microns, par exemple 5 microns, 7 microns ou encore 10 microns, pour le diamètre d'un contour circulaire ou le côté d'un contour carré ou rectangulaire.

Selon une deuxième variante, le pilier 30 ou tout ou partie d'une pluralité de piliers 30 rejoint au moins une paroi périphérique 23b de la cavité 23. Plusieurs exemples de piliers 30, formant chacun une cloison, sont illustrés sur la figure 2g. Selon un exemple, la surface supérieure 31 du pilier 30 (ou des piliers) forme un quadrillage joignant les parois périphériques 23b de la cavité 23. Selon un autre exemple, certains piliers 30 dans une cavité rejoignent une paroi périphérique 23b et d'autres sont disjoints. Selon encore un autre exemple, les piliers 30 forment un réseau de cloisons parallèles rejoignant en leurs extrémités des parois périphériques 23b de la cavité 23.

Selon cette deuxième variante, le pilier 30 pourra présenter une largeur allant de quelques microns à environ 15 microns, par exemple 5 microns, 7 microns ou encore 10 microns. Il pourra présenter une longueur allant de quelques microns jusqu'à une dimension permettant de rejoindre les parois périphériques 23b de la cavité 23, donc de l'ordre de grandeur des dimensions de ladite cavité 23.

Le procédé de transfert selon l'invention comprend également une étape d'assemblage du substrat donneur 1 et du substrat support 20 au niveau de la première face 21 du substrat support 20 (figure 2h).

Avantageusement, cette étape comprend le collage direct, par adhésion moléculaire, entre, d'une part, la face avant 11 du substrat donneur 1, et d'autre part, la première face 21 du substrat support 20 et la surface supérieure 31 du (au moins un) pilier 30. Le principe de l'adhésion moléculaire, bien connu dans l'état de l'art ne sera pas décrit plus en détail ici. Notons qu'un très bon état de surface (propreté, faible rugosité, ...) des substrats à assembler est requis, pour obtenir une bonne qualité d'assemblage.

En particulier, il faudra apporter une attention particulière à obtenir une bonne coplanarité entre la première face 21 du substrat support 20 et la surface supérieure 31 de chaque pilier 30, de manière à assurer un collage efficace de ladite première face 21 et de ladite surface supérieure 31, avec la face avant 11 du substrat donneur 1.

Avantageusement, pour garantir une bonne qualité d'assemblage, l'étape d'assemblage comprend un nettoyage des surfaces à assembler du substrat donneur 1 et du substrat support 20, préalablement à la mise en contact desdites surfaces. A titre d'exemple, une séquence classique utilisée en microélectronique, notamment pour des substrats à base de silicium, comprend un nettoyage à l'ozone, un nettoyage de type SC1 (« Standard Clean 1 ») et un nettoyage de type SC2 (« Standard Clean 2 »), avec des rinçages intercalés. Une activation des surfaces à assembler, par exemple par plasma, pourra également être réalisée avant la mise en contact, pour favoriser une forte énergie de collage entre lesdites surfaces.

Optionnellement, le substrat donneur 1 et/ou le substrat support 20 pourront comprendre une couche de collage, respectivement au niveau de la face avant 11 et/ou au niveau de la première face 21, pour favoriser la qualité de collage et l'énergie de collage de leur interface.

Le procédé de transfert comprend ensuite une étape d'amincissement du substrat donneur 1 de manière à former la couche superficielle 10.

Selon une première variante, l'étape d'amincissement du substrat donneur 1 est opérée par rectification mécanique (« grinding »), par polissage mécano-chimique et/ou par gravure chimique au niveau de sa face arrière 12. A l'issue de l'étape d'amincissement, on obtient la couche superficielle 10 transférée sur le substrat support 20 (figure 2i).

Selon une deuxième variante avantageuse, l'amincissement est réalisé à partir du procédé Smart Cut^{™}, basé sur une implantation d'ions légers et un détachement au niveau de la zone implantée.

Ainsi, selon cette deuxième variante, l'étape de fourniture du substrat donneur 1 précédemment énoncée, comprend l'implantation d'espèces légères dans ledit substrat donneur 1, de manière à former une zone fragile enterrée 2 s'étendant entre une première partie 3 du substrat donneur 1, destinée à former la couche superficielle 10, et une deuxième partie 4 destinée à constituer le reste du substrat donneur 1 (figure 3a).

L'énergie d'implantation des espèces légères (par exemple hydrogène ou hélium) conditionne l'épaisseur de la première partie 3, et donc de la future couche superficielle 10. Avantageusement, l'énergie d'implantation est choisie de manière à ce que la première partie 3 du substrat donneur 1 présente une épaisseur de l'ordre de 0,2 micron - 2 microns.

Le substrat donneur 1 est ensuite assemblé au substrat support 20 conformément à l'étape d'assemblage du procédé (figure 3b).

Toujours selon cette deuxième variante avantageuse, l'étape d'amincissement du substrat donneur 1 comprend la séparation, au niveau de la zone fragile enterrée 2, entre la couche superficielle 10 (formée par la première partie 3 détachée) et le reste 4 du substrat donneur 1 (figure 3c). Cette séparation est préférentiellement réalisée au cours d'un traitement thermique à une température comprise entre quelques centaines de degrés et 700°C. Elle pourra alternativement être assistée mécaniquement ou réalisée après le traitement thermique, au moyen d'une sollicitation mécanique.

A l'issue de l'étape d'amincissement, on obtient la couche superficielle 10 transférée sur le substrat support 20 (figure 3c). Rappelons que le procédé Smart Cut^{™} permet l'obtention de couches minces présentant une excellente uniformité d'épaisseur. Ce critère peut être très intéressant pour certains dispositifs MEMS requérant des membranes flexibles d'épaisseur contrôlée.

Dans certains cas où l'épaisseur de la couche superficielle 10 transférée par le procédé Smart Cut^{™} est insuffisante, il est possible de ré-augmenter cette épaisseur en déposant une couche additionnelle sur la surface libre 12' de la couche superficielle 10, par exemple par croissance épitaxiale ou autres méthodes de dépôt connues, au cours d'un traitement de finition évoqué ci-après.

Selon l'une et l'autre des variantes énoncées, après le transfert de la couche superficielle 10 sur le substrat support 20, l'étape d'amincissement peut comprendre un traitement de finition visant à améliorer la qualité cristalline (élimination de défauts dans la couche), la qualité de surface (élimination de la rugosité résiduelle sur la surface libre 12') et/ou à modifier l'épaisseur de la couche superficielle 10. Ce traitement pourra inclure un ou plusieurs traitement(s) thermique(s), polissage(s) mécano-chimique(s), gravure(s) chimique(s), croissance épitaxiale, et/ou dépôt de couches additionnelles.

Le rôle du (au moins un) pilier temporaire 30 situé dans la cavité 23 est de soutenir mécaniquement la couche superficielle 10 au cours de l'étape d'amincissement.

La couche superficielle 10 surplombant la cavité 23 est susceptible de se déformer au cours d'un amincissement mécano-chimique selon la première variante énoncée ci-dessus.

Plus encore, selon la deuxième variante évoquée, la couche superficielle 10 risque de ne pas être transférée en vis-à-vis de la cavité 23, s'il n'y a pas un effet raidisseur suffisant contre la face avant 11 du substrat donneur 1, au cours de la fragilisation de la zone fragile enterrée 2 et jusqu'à la séparation entre la première 3 et la deuxième 4 partie du substrat donneur 1. Le (au moins un) pilier temporaire 30 disposé dans la cavité 23 assure cet effet raidisseur contre la face avant 11 et permet ainsi le transfert complet de la couche superficielle 10 sur l'ensemble du substrat support 20, et notamment au-dessus des cavités 23.

Avantageusement, pour une couche superficielle 10 d'une épaisseur de l'ordre de 1 micron à 1,5 micron, l'espacement entre les piliers 30 eux-mêmes et l'espacement entre les parois périphériques 23b de la cavité 23 et chaque pilier 30 est choisi entre 10 microns et 50 microns, préférentiellement de l'ordre de 20 microns.

Le procédé de transfert selon l'invention comprend enfin une étape de retrait du (au moins un) pilier temporaire 30.

Le retrait du pilier 30 peut comprendre la gravure locale de la couche superficielle 10 pour former au moins une ouverture 13a, 13b, 13c traversant ladite couche superficielle 10.

Une telle gravure locale peut être réalisée par photolithographie et gravure chimique sèche ou humide. En particulier, un masque déposé sur la face libre 12' de la couche superficielle 10 permet de délimiter les zones à graver pour former les ouvertures et de protéger le reste de la surface libre 12'. Notons que des marques d'alignement, définies sur la périphérie du substrat support 20 et/ou dans des zones prévues pour des chemins de découpe sur sa première face 21 et/ou au niveau de la seconde face 22 du substrat support 20, lors de la formation des cavités 23 et des piliers 30 sur le substrat support 20, permettent un positionnement précis vis-à-vis des piliers 30 et des cavités 23 enterrés lors de l'étape de retrait du ou des pilier(s). Ces marques pourront également servir pour des étapes ultérieures nécessitant un alignement vis-à-vis des cavités 23 sur la structure 100 à cavités enterrées.

Les figures 4a, 4b, 4c représentent des agrandissements en vue de dessus de la couche superficielle 10, le contour de la cavité 23 sous-jacente ainsi que les surfaces supérieures 31 des piliers 30 apparaissent en pointillés. L'ouverture 13a, 13b, 13c peut notamment être réalisée selon l'une ou l'autre des configurations présentées sur ces figures.

Comme illustré sur la figure 4a, l'ouverture 13a peut être réalisée à l'aplomb de chaque pilier 30, et présenter une section inférieure à la surface supérieure 31 du pilier 30. Une gravure chimique sèche ou humide apte à attaquer le matériau du pilier 30 est ensuite effectuée, via l'ouverture 13a, pour éliminer le pilier 30 et libérer la couche superficielle 10 sur toute l'étendue de la cavité 23.

Alternativement, l'ouverture 13b peut être réalisée à l'aplomb de chaque pilier 30, et présenter une section supérieure à la surface supérieure 31 du pilier 30 (figure 4b). Une gravure chimique sèche ou humide est effectuée, via l'ouverture 13a, pour éliminer le pilier 30 et libérer la couche superficielle 10 sur l'étendue de la cavité 23.

Encore alternativement, l'ouverture 13c (ou une pluralité d'ouvertures) peut être réalisée dans une zone de la couche superficielle 10 surplombant la cavité 23 (figure 4c). Une gravure chimique humide est effectuée, via l'ouverture 13a, pour éliminer le pilier 30 et libérer la couche superficielle 10 sur toute l'étendue de la cavité 23.

Notons que, pour chacune des configurations présentées sur les figures 4a, 4b et 4c, il est possible de reboucher les ouvertures 13a,13b,13c, par exemple par dépôt de silicium poly-cristallin, sous vide ou atmosphère contrôlée.

Selon une variante (non représentée), le retrait du pilier 30 peut comprendre la gravure locale de la couche superficielle 10 pour former au moins une ouverture 13 traversant ladite couche superficielle 10 dans une zone non située à l'aplomb d'une cavité 23. Dans ce cas, l'ouverture 13 débouche dans un canal latéral, aménagé dans le substrat support 20 préalablement à l'étape d'assemblage du procédé ; ce canal latéral communique avec une ou plusieurs cavités 23 environnantes. Une gravure chimique humide ou sèche peut alors être effectuée, via l'ouverture 13 et le canal latéral, pour éliminer le (au moins un) pilier 30 et libérer la couche superficielle 10 sur toute l'étendue de la cavité 23.

Notons que cette variante permet de laisser la membrane (partie de la couche superficielle 10 située à l'aplomb d'une cavité 23) intègre en évitant que l'ouverture 13 ne la traverse.

Selon une autre variante (non représentée), le retrait du pilier 30 peut comprendre la formation d'au moins une ouverture 13 par gravure locale de la seconde face 22 du substrat support 20, jusqu'à la cavité 23. Avantageusement, une telle gravure au niveau de la seconde face 22 est réalisée en fin de fabrication du dispositif MEMS, quand le substrat support 20 est aminci par exemple à 400, 200, 100, 50 microns ou moins. Cela permet de réaliser une ouverture 13 de petite taille tout en restant dans les ratios épaisseur gravée / dimensions de l'ouverture accessibles par les techniques connues de gravure chimique.

A l'issue de l'étape de retrait du ou des pilier(s) temporaire(s) 30, on obtient une structure 100 à cavités enterrées, adaptée pour la fabrication de dispositifs MEMS car la géométrie des cavités 23, l'épaisseur de la couche superficielle 10 (membrane flexible) ainsi que la répartition planaire des cavités/membranes sont conformes au cahier des charge des dispositifs MEMS. Le procédé de transfert selon l'invention permet de reporter une couche superficielle 10 de haute qualité, et en particulier une couche 10 présentant une faible épaisseur (inférieure à quelques microns), sur des cavités de toute géométrie, et en particulier des cavités présentant de grandes dimensions (supérieures à quelques dizaines de microns), grâce à l'utilisation de piliers temporaires 30, présents dans les cavités 23, pendant l'étape d'amincissement formant la couche superficielle 10.

### Exemple de mise en oeuvre :

Dans le présent exemple, on cherche à former une structure 100 à cavités enterrées 23 comportant une couche superficielle en silicium de 1,5 micron d'épaisseur et des cavités de 250 microns de côté, de 0,5 micron de profondeur et espacées de 100 microns.

Le substrat donneur 1 est un substrat en silicium (figure 5a). Une couche d'oxyde 5, par exemple de l'ordre de 50 nm, est formée, par exemple par oxydation thermique, sur sa face avant 11 préalablement à l'implantation des espèces légères. L'énergie d'implantation est choisie à 210 keV, avec des espèces d'hydrogène à une dose de l'ordre de 7^{E}16/cm2. On forme ainsi une zone fragile enterrée 2, s'étendant entre une première partie 3 et une deuxième partie 4 du substrat 1.

La couche d'oxyde 5 pourra être conservée ou retirée préalablement à l'étape d'assemblage sur le substrat support 20.

Le substrat support 20 est un substrat en silicium. Une couche d'oxyde thermique 24 présentant une épaisseur de 0,5 micron est formée sur ledit substrat 20 au niveau de sa première face 21 et de sa seconde face 22. La couche d'oxyde thermique présente au niveau de la seconde face 22 pourra être conservée en tout ou partie, ou retirée selon les cas. Alternativement, une couche d'oxyde pourra être déposée (par une technique connue de dépôt) uniquement au niveau de la première face 21 du substrat support 20.

Par photolithographie, un masque 25 est ensuite défini sur la première face 21 du substrat support 20, comportant des zones non masquées au niveau desquelles la couche d'oxyde thermique 24 pourra être gravée et des zones masquées au niveau desquelles ladite couche 24 sera protégée (figure 5b). Notons que des marques d'alignement sont également définies sur la périphérie du substrat support 20 et/ou dans des zones de chemins de découpe, pour les étapes ultérieures de photolithographie qui viseront à retrouver les coordonnées des cavités 23, lorsqu'elles seront enterrées sous la couche superficielle 10.

Les zones non masquées sont définies selon la taille et la répartition planaire visée des cavités 23 de la structure 100, d'une part, et selon la disposition des piliers temporaires 30, d'autre part.

Typiquement, dans le cas présent, chaque cavité 23 mesure 250 microns de côté, et on dispose des piliers 30 temporaires à 25 microns des parois périphériques 23b de la cavité 23 et espacés entre eux de 25 microns. La surface supérieure 31 de chaque pilier 30 est carrée avec un côté de 7 microns ; alternativement, la surface supérieure 31 pourra être circulaire avec un diamètre de 7 microns ou en forme de croix avec la plus grande des dimensions de la croix définie à 7 microns.

Au niveau des zones non masquées, on opère la gravure chimique sèche ou humide, de la couche d'oxyde thermique 24, sur toute son épaisseur, soit 0,5 micron (figure 5c). Le masque 25 est ensuite retiré.

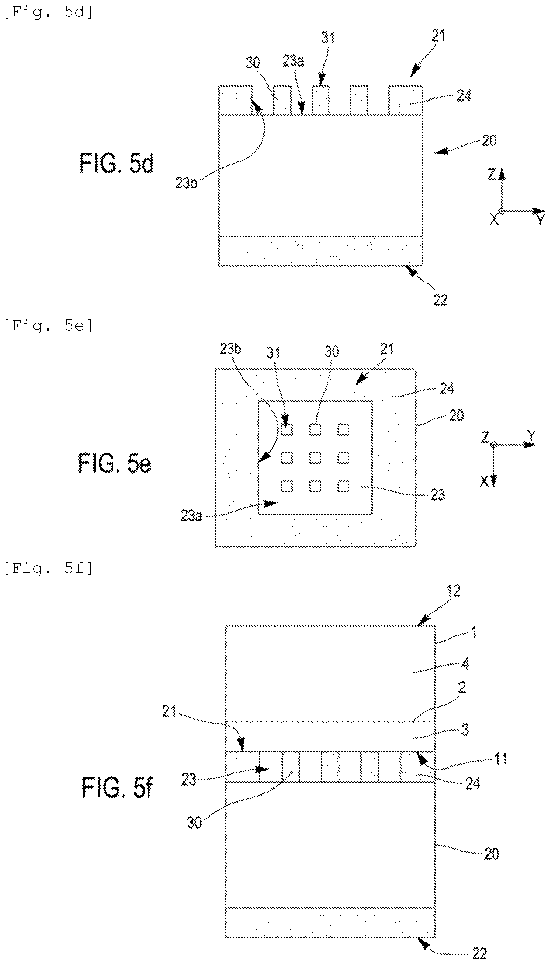

On obtient ainsi le substrat support 20 comportant une pluralité de cavités débouchant au niveau de sa première face 21 et dans lesquelles sont disposés des piliers temporaires 30 dont la surface supérieure 31 est coplanaire avec la première face 21 dudit substrat 20 (figures 5d et 5e).

Après une séquence de nettoyage et d'activation, la face avant 11 du substrat donneur 1 et la première face 21 du substrat support 20 sont mises en contact et collées par adhésion moléculaire (figure 5f). Notons que le collage direct pourra être réalisé sous atmosphère ambiante ou atmosphère contrôlée (pression et nature du gaz) ou sous vide. Un recuit de consolidation de l'interface de collage peut être appliqué à la structure collée à une température de l'ordre de 350°C.

La séparation au niveau de la zone fragile enterrée 2 s'effectue au cours d'un traitement thermique de détachement, à une température de l'ordre de 500°C.

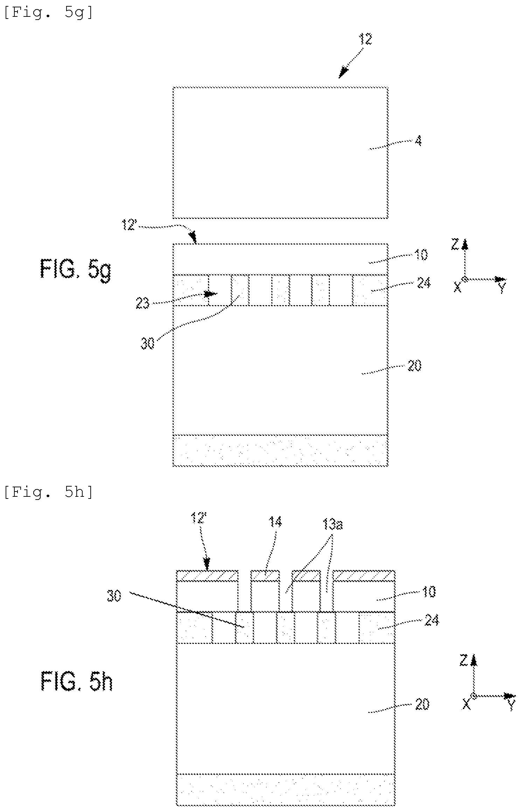

On obtient alors la couche superficielle 10 transférée sur le substrat support 20 (figure 5g).

Des traitements de finition, tels qu'un traitement thermique oxydant et un polissage mécano-chimique sont préférentiellement opérés pour garantir une bonne qualité structurelle et de surface à la couche superficielle 10 transférée et pour aboutir à une épaisseur de 1,5 micron.

Pour l'étape de retrait des piliers 30 temporaires, un masque 14, par exemple en nitrure de silicium, est défini par photolithographie, à partir des marques d'alignement prévues sur le substrat support 20, pour délimiter des zones non masquées au niveau desquelles seront formées les ouvertures 13a traversant la couche superficielle, le reste de la face libre 12 de la couche superficielle 10 étant masqué et donc protégé. Une gravure locale sèche ou humide de la couche superficielle 10 en silicium est opérée pour former les ouvertures 13a, la section de chaque ouverture 13a étant choisie ici inférieure à la surface supérieure 31 de chaque pilier 30 (figure 5h).

En présence des ouvertures 13a, une gravure chimique, par exemple sèche, à base de vapeurs d'acide fluorhydrique (HF) est effectuée pour éliminer l'oxyde thermique constituant les piliers 30, et ainsi libérer la couche superficielle 10 sur toute l'étendue de la cavité 23.

Le masque 14 peut être retiré, avant la gravure chimique des piliers 30 ou à l'issue de l'étape de retrait des piliers 30.

Les ouvertures 13a peuvent ensuite être rebouchées si nécessaire.

On obtient une structure 100 à cavités enterrées 23 (figure 5i), adaptée pour la fabrication de dispositifs MEMS car la géométrie des cavités 23, l'épaisseur de la couche superficielle 10 (membrane flexible) ainsi que la répartition planaire des cavités/membranes sont conformes au cahier des charges énoncé précédemment. Le procédé de transfert selon l'invention permet de reporter une couche superficielle 10 de haute qualité, et en particulier une couche 10 présentant une faible épaisseur (environ 1 micron dans cet exemple), sur des cavités de toute géométrie, et en particulier des cavités présentant de grandes dimensions (250 x 250 microns dans cet exemple), grâce à l'utilisation de piliers temporaires 30, disposés dans les cavités 23, pendant l'étape d'amincissement formant la couche superficielle 10.

Bien entendu, l'invention n'est pas limitée aux modes de mise en oeuvre et exemples décrits, et on peut y apporter des variantes de réalisation sans sortir du cadre de l'invention tel que défini par les revendications.

## Revendications

1. Procédé de transfert d'une couche superficielle (10) sur un substrat support (20) comportant des cavités (23), le procédé comprenant :
- La fourniture d'un substrat donneur (1),
- La fourniture du substrat support (20) présentant une première face (21) et comportant des cavités (23), chaque cavité (23) débouchant au niveau de ladite première face (21) et présentant un fond (23a) et des parois périphériques (23b),
- La réalisation d'au moins un pilier temporaire (30) dans au moins une des cavités (23), le pilier (30) présentant une surface supérieure (31) coplanaire avec la première face (21) du substrat support (20),
- L'assemblage du substrat donneur (1) et du substrat support (20) au niveau de la première face (21) du substrat support (20),
- L'amincissement du substrat donneur (1) de manière à former la couche superficielle (10),
- Le retrait du au moins un pilier temporaire (30).

2. Procédé de transfert selon la revendication précédente, dans lequel :
- la fourniture du substrat donneur (1) comprend l'implantation d'espèces légères dans ledit substrat donneur (1), de manière à former une zone fragile enterrée (2) s'étendant entre une première partie (3) du substrat donneur (1), destinée à former la couche superficielle (10), et une deuxième partie (4) du substrat donneur (1) destinée à former le reste (4) du substrat donneur (1),
- l'amincissement du substrat donneur (1) comprend la séparation, au niveau de la zone fragile enterrée (2), entre la couche superficielle (10) et le reste (4) du substrat donneur.

3. Procédé de transfert selon la revendication précédente, dans lequel la première partie (3) du substrat donneur (1) présente une épaisseur comprise entre 0,2 µm et 2 µm.

4. Procédé de transfert selon la revendication 1, dans lequel l'amincissement du substrat donneur (1) comprend au moins une rectification mécanique et/ou au moins un polissage mécano-chimique et/ou au moins une gravure chimique au niveau de sa face arrière (12).

5. Procédé de transfert selon l'une des revendications précédentes, dans lequel le pilier (30) est disjoint des parois périphériques (23b) de la cavité (23).

6. Procédé de transfert selon la revendication précédente, dans lequel la surface supérieure (31) du pilier (30) présente un contour circulaire, carré, rectangulaire ou en croix.

7. Procédé de transfert selon l'une des revendications 1 à 4, dans lequel le au moins un pilier (30) rejoint au moins une paroi périphérique (23b) de la cavité (23).

8. Procédé de transfert selon la revendication précédente, dans lequel la surface supérieure (31) du au moins un pilier (30) forme un quadrillage joignant les parois périphériques (23b) de la cavité (23).

9. Procédé de transfert selon la revendication 7, dans lequel une pluralité de piliers (30) forme un réseau de parois parallèles rejoignant en leurs extrémités des parois périphériques (23b) de la cavité (23).

10. Procédé de transfert selon l'une des revendications précédentes, dans lequel l'assemblage comprend le collage par adhésion moléculaire entre, d'une part, le substrat donneur (1), et d'autre part, la première face (21) du substrat support (20) et la surface supérieure (31) du au moins un pilier (30).

11. Procédé de transfert selon l'une des revendications précédentes, dans lequel le retrait du pilier (30) comprend la gravure locale de la couche superficielle (10) pour former une ouverture (13,13a,13b,13c) traversant ladite couche superficielle (10), et la gravure chimique du pilier (30) via ladite ouverture.

12. Procédé de transfert selon la revendication précédente, dans lequel l'ouverture (13,13a,13b) est faite à l'aplomb du pilier (30).

13. Procédé de transfert selon l'une des deux revendications précédentes, dans lequel l'ouverture (13a) présente une section inférieure à la surface supérieure (31) du pilier (30).

14. Procédé de transfert selon l'une des revendications 11 ou 12, dans lequel l'ouverture (13b) présente une section supérieure à la surface supérieure (31) du pilier (30).

15. Procédé de transfert selon la revendication 11, dans lequel l'ouverture (13) est faite dans la couche superficielle (10), en-dehors de zones surplombant la au moins une cavité.

16. Procédé de transfert selon l'une des revendications 1 à 10, dans lequel le retrait du pilier (30) comprend la gravure locale d'une seconde face (22) du substrat support (20) jusqu'à la cavité (23), pour former une ouverture communiquant avec ladite cavité, et la gravure chimique du pilier (30) via ladite ouverture.

17. Procédé de transfert selon l'une des revendications précédentes, dans lequel le pilier (30) comprend au moins un matériau compris parmi l'oxyde de silicium, le nitrure de silicium, le silicium monocristallin, poly-cristallin, amorphe ou poreux.

18. Procédé de transfert selon l'une des revendications précédentes, dans lequel le substrat donneur (1) comprend au moins un matériau semi-conducteur ou piézoélectrique.

## Patentansprüche

1. Verfahren zum Übertragen einer Oberflächenschicht (10) auf ein Trägersubstrat (20), das Hohlräume (23) aufweist, wobei das Verfahren umfasst:
- Bereitstellung eines Spendersubstrats (1),
- Bereitstellung des Trägersubstrats (20), das eine erste Seite (21) vorweist und Hohlräume (23) aufweist, wobei jeder Hohlraum (23) auf der ersten Seite (21) mündet und einen Boden (23a) und Umfangswände (23b) vorweist,
- Herstellung mindestens einer temporären Säule (30) in mindestens einem der Hohlräume (23), wobei die Säule (30) eine obere Oberfläche (31) vorweist, die mit der ersten Seite (21) des Trägersubstrats (20) koplanar ist,
- Zusammenfügen des Spendersubstrats (1) und des Trägersubstrats (20) auf der ersten Seite (21) des Trägersubstrats (20),
- Ausdünnen des Spendersubstrats (1), um die Oberflächenschicht (10) zu bilden,
- Entfernen der mindestens einen temporären Säule (30).

2. Übertragungsverfahren nach dem vorstehenden Anspruch, wobei:
- die Bereitstellung des Spendersubstrats (1) das Implantieren leichter Spezies in das Spendersubstrat (1) umfasst, um einen vergrabenen fragilen Bereich (2) zu bilden, der sich zwischen einem ersten Teil (3) des Spendersubstrats (1), der dazu bestimmt ist, die Oberflächenschicht (10) zu bilden, und einem zweiten Teil (4) des Spendersubstrats (1), der dazu bestimmt ist, den Rest (4) des Spendersubstrats (1) zu bilden, erstreckt,
- das Ausdünnen des Spendersubstrats (1) die Absonderung, auf dem vergrabenen fragilen Bereich (2), zwischen der Oberflächenschicht (10) und dem Rest (4) des Spendersubstrats umfasst.

3. Übertragungsverfahren nach dem vorstehenden Anspruch, wobei der erste Teil (3) des Spendersubstrats (1) eine Dicke zwischen 0,2 µm und 2 µm vorweist.

4. Übertragungsverfahren nach Anspruch 1, wobei das Ausdünnen des Spendersubstrats (1) mindestens mechanisches Schleifen und/oder mindestens chemisch-mechanisches Polieren und/oder mindestens chemisches Ätzen auf seiner Rückseite (12) umfasst.

5. Übertragungsverfahren nach einem der vorstehenden Ansprüche, wobei die Säule (30) von den Umfangswänden (23b) des Hohlraums (23) getrennt ist.

6. Übertragungsverfahren nach dem vorstehenden Anspruch, wobei die obere Oberfläche (31) der Säule (30) eine kreisförmige, quadratische, rechteckige oder kreuzförmige Kontur vorweist.

7. Übertragungsverfahren nach einem der Ansprüche 1 bis 4, wobei die mindestens eine Säule (30) an mindestens eine Umfangswand (23b) des Hohlraums (23) anschließt.

8. Übertragungsverfahren nach dem vorstehenden Anspruch, wobei die obere Oberfläche (31) der mindestens einen Säule (30) ein Gitter bildet, das die Umfangswände (23b) des Hohlraums (23) verbindet.

9. Übertragungsverfahren nach Anspruch 7, wobei eine Vielzahl von Säulen (30) ein Netz von parallelen Wänden bildet, die an ihren Enden an Umfangswände (23b) des Hohlraums (23) anschließen.

10. Übertragungsverfahren nach einem der vorstehenden Ansprüche, wobei das Zusammenfügen das Verkleben durch molekulare Adhäsion zwischen dem Spendersubstrat (1) einerseits und der ersten Seite (21) des Trägersubstrats (20) und der oberen Oberfläche (31) der mindestens einen Säule (30) andererseits umfasst.

11. Übertragungsverfahren nach einem der vorstehenden Ansprüche, wobei das Entfernen der Säule (30) das lokale Ätzen der Oberflächenschicht (10) zum Bilden einer Öffnung (13, 13a, 13b, 13c), die durch die Oberflächenschicht (10) verläuft, und das chemische Ätzen der Säule (30) über die Öffnung umfasst.

12. Übertragungsverfahren nach dem vorstehenden Anspruch, wobei die Öffnung (13, 13a, 13b) lotrecht zu der Säule (30) ausgeführt ist.

13. Übertragungsverfahren nach einem der zwei vorstehenden Ansprüche, wobei die Öffnung (13a) einen Querschnitt vorweist, der kleiner als die obere Oberfläche (31) der Säule (30) ist.

14. Übertragungsverfahren nach einem der Ansprüche 11 oder 12, wobei die Öffnung (13b) einen Querschnitt vorweist, der größer als die obere Oberfläche (31) der Säule (30) ist.

15. Übertragungsverfahren nach Anspruch 11, wobei die Öffnung (13) in der Oberflächenschicht (10) außerhalb von Bereichen, die über den mindestens einen Hohlraum hinausragen, ausgeführt ist.

16. Übertragungsverfahren nach einem der Ansprüche 1 bis 10, wobei das Entfernen der Säule (30) das lokale Ätzen einer zweiten Seite (22) des Trägersubstrats (20) bis zu dem Hohlraum (23), um eine Öffnung zu bilden, die mit dem Hohlraum kommuniziert, und das chemische Ätzen der Säule (30) durch die Öffnung umfasst.

17. Übertragungsverfahren nach einem der vorstehenden Ansprüche, wobei die Säule (30) mindestens ein Material umfasst, das ausgewählt ist aus Siliziumoxid, Siliziumnitrid, monokristallinem, polykristallinem, amorphem oder porösem Silizium.

18. Übertragungsverfahren nach einem der vorstehenden Ansprüche, wobei das Spendersubstrat (1) mindestens ein halbleitendes oder piezoelektrisches Material umfasst.

## Claims

1. Method for transferring a surface layer (10) onto a support substrate (20) comprising cavities (23), the method including:
- providing a donor substrate (1),
- providing the support substrate (20) having a first face (21) and comprising cavities (23), each cavity (23) opening onto said first face (21) and having a base (23a) and peripheral walls (23b),
- producing at least one temporary pillar (30) in at least one of the cavities (23), the pillar (30) having an upper surface (31) coplanar with the first face (21) of the support substrate (20),
- joining the donor substrate (1) and the support substrate (20) at the first face (21) of the support substrate (20),
- thinning the donor substrate (1) so as to form the surface layer (10),
- removing the at least one temporary pillar (30).

2. Transfer method according to the preceding claim, wherein:
- providing the donor substrate (1) includes implanting light species in said donor substrate (1) so as to form a buried fragile zone (2) extending between a first part (3) of the donor substrate (1) intended to form the surface layer (10) and a second part (4) of the donor substrate (1) intended to form the remainder (4) of the donor substrate (1),
- thinning the donor substrate (1) includes separating, at the buried fragile zone (2), the surface layer (10) and the remainder (4) of the donor substrate.

3. Transfer method according to the preceding claim, wherein the first part (3) of the donor substrate (1) has a thickness of between 0.2 µm and 2 µm.

4. Transfer method according to claim 1, wherein thinning the donor substrate (1) includes at least one mechanical grinding operation and/or at least one chemical-mechanical polishing operation and/or at least one chemical etching operation at its rear face (12).

5. Transfer method according to any of the preceding claims, wherein the pillar (30) is separate from the peripheral walls (23b) of the cavity (23).

6. Transfer method according to the preceding claim, wherein the upper surface (31) of the pillar (30) has a circular, square, rectangular or cruciform contour.

7. Transfer method according to any of claims 1 to 4, wherein the at least one pillar (30) joins at least one peripheral wall (23b) of the cavity (23).

8. Transfer method according to the preceding claim, wherein the upper surface (31) of the at least one pillar (30) forms a grid that joins the peripheral walls (23b) of the cavity (23).

9. Transfer method according to claim 7, wherein a plurality of pillars (30) forms a network of parallel walls that join, at their ends, peripheral walls (23b) of the cavity (23).

10. Transfer method according to any of the preceding claims, wherein the assembly includes bonding by molecular adhesion between, on the one hand, the donor substrate (1), and on the other hand, the first face (21) of the support substrate (20) and the upper surface (31) of the at least one pillar (30).

11. Transfer method according to any of the preceding claims, wherein removing the pillar (30) includes locally etching the surface layer (10) to form an opening (13, 13a, 13b, 13c) passing through said surface layer (10), and chemically etching the pillar (30) via said opening.

12. Transfer method according to the preceding claim, wherein the opening (13, 13a, 13b) is made in line with the pillar (30).

13. Transfer method according to either of the two preceding claims, wherein the opening (13a) has a cross section smaller than the upper surface (31) of the pillar (30).

14. Transfer method according to either claim 11 or claim 12, wherein the opening (13b) has a cross section greater than the upper surface (31) of the pillar (30).

15. Transfer method according to claim 11, wherein the opening (13) is made in the surface layer (10), outside of zones overhanging the at least one cavity.

16. Transfer method according to any of claims 1 to 10, wherein removing the pillar (30) includes locally etching a second face (22) of the support substrate (20) as far as the cavity (23), to form an opening communicating with said cavity, and chemically etching the pillar (30) via said opening.

17. Transfer method according to any of the preceding claims, wherein the pillar (30) includes at least one material included among silicon oxide, silicon nitride, and monocrystalline, polycrystalline, amorphous or porous silicon.

18. Transfer method according to any of the preceding claims, wherein the donor substrate (1) includes at least one semiconductor material or piezoelectric material.
